(19) Europäisches Patentamt European Patent Office Office européen des brevets

(11) **EP 1 774 351 B1**

(12) **EUROPÄISCHE PATENTSCHRIFT**

(45) Veröffentlichungstag und Bekanntmachung des Hinweises auf die Patenterteilung:
**09.07.2008 Patentblatt 2008/28**

(21) Anmeldenummer: **05753994.2**

(22) Anmeldetag: **31.05.2005**

(51) Int Cl.:
*G01R 31/36* *(2006.01)*

(86) Internationale Anmeldenummer:
**PCT/EP2005/052468**

(87) Internationale Veröffentlichungsnummer:
**WO 2006/010659 (02.02.2006 Gazette 2006/05)**

(54) **ZUSTANDS- UND PARAMETERSCHÄTZER MIT INTEGRAL- UND DIFFERENTIALANTEIL FUR ELEKTRISCHE ENERGIESPEICHER**

STATE AND PARAMETER ESTIMATOR COMPRISING AN INTEGRAL OR DIFFERENTIAL PORTION FOR ELECTRICAL ENERGY STORES

ESTIMATEUR DE VARIABLES D'ETAT ET DE PARAMETRES A COMPOSANTE INTEGRALE ET DIFFERENTIELLE POUR ACCUMULATEURS D'ENERGIE ELECTRIQUE

(84) Benannte Vertragsstaaten:
**DE ES FR GB IT SE**

(30) Priorität: **23.07.2004 DE 102004035858**

(43) Veröffentlichungstag der Anmeldung:
**18.04.2007 Patentblatt 2007/16**

(73) Patentinhaber: **ROBERT BOSCH GMBH**
**70442 Stuttgart (DE)**

(72) Erfinder: **SCHOCH, Eberhard**
**70469 Stuttgart (DE)**

(56) Entgegenhaltungen:
EP-A- 0 505 333     US-A- 4 390 841
US-A- 5 349 540     US-A- 5 596 260
US-A1- 2004 032 264

**Beschreibung**

Die Erfindung betrifft eine Vorrichtung zum Ermitteln von Zustandsgrößen und/oder Parametern eines mathematischen Energiespeichermodells, insbesondere eines Batteriemodells, gemäß dem Oberbegriff des Patentanspruchs 1, sowie ein entsprechendes Verfahren gemäß dem Oberbegriff des Patentanspruchs 5.

In elektrischen Netzen, wie z.B. Kfz-Bordnetzen, die von einer Batterie mit elektrischer Energie versorgt werden, ist es insbesondere unter sicherheitstechnischen Aspekten wichtig, die aktuelle Leistungsfähigkeit der Batterie zu kennen. Im Bereich der Kraftfahrzeugtechnik ist es bekannt, aus den aktuellen Betriebsgrößen der Batterie, insbesondere der Batteriespannung, dem Batteriestrom und der Batterietemperatur, den Ladezustand (SOC) oder den Alterungszustand (SOH) der Batterie zu berechnen. Diese Art der Batteriezustandserkennung ergibt zwar eine Aussage über den Ladezustand bzw. Alterungszustand der Batterie, nicht jedoch über die tatsächlich aktuell abgebbare Leistung und entnehmbare Ladung der Batterie. Aus diesem Grund wurden bereits mathematische Energiespeichermodelle vorgeschlagen, mit denen die Belastbarkeit bzw. entnehmbare Ladung eines elektrischen Energiespeichers genauer bestimmt werden kann. Dabei handelt es sich um mathematische Modelle, die die elektrischen Eigenschaften des Energiespeichers anhand verschiedener mathematischer Beziehungen darstellen. Die mathematischen Beziehungen beschreiben funktionale Zusammenhänge zwischen verschiedenen Zustandsgrößen, wie z.B. Batterie internen Spannungen, Strömen, etc. und umfassen verschiedene Parameter, die das elektrische und gegebenenfalls auch das thermische Verhalten des Energiespeichers abbilden.

Bekannte Batteriemodelle umfassen üblicherweise einen in einem Steuergerät als Software hinterlegten Zustandsgrößen- und Parameterschätzer, mit dem die verschiedenen Zustandsgrößen und Parameter des Energiespeichermodells berechnet werden, sowie eine Vorhersageeinrichtung (Prädiktor), der unter Berücksichtigung eines vorgegebenen Belastungsprofils, wie z.B. eines Stromverlaufs oder Lastverlaufs, eine Vorhersage über einen zukünftigen Batteriezustand (z.B. eine Batteriespannung) oder über die aus der Batterie entnehmbare Ladung, treffen kann. Bekannte Zustandsgrößen- und Parameterschätzer liefern jedoch relativ ungenaue Ergebnisse für die gewünschten Parameter, insbesondere für die Kapazität oder den Innenwiderstand der Batterie, und sind daher für eine Modell basierte Prädiktion nicht geeignet, oder sie sind relativ kompliziert aufgebaut.

Es ist daher die Aufgabe der vorliegenden Erfindung, einen Zustandsgrößen- und Parameterschätzer für elektrische Energiespeicher zu schaffen, der das Betriebsverhalten des elektrischen Energiespeichers genauer abbildet und somit eine bessere Prädiktion von Batteriegrößen oder -Parametern ermöglicht .

Aus der US-A-5349540 ist bereits ein Energiespeichermodell bekannt, weiches den Fehler zwischen einer gemessenen und einer vom Energiespeichermodell berechneten Batteriegröße berechnet. Der Schätzfehler zwischen berechneter -und gemessener Batteriebetriebsgröße zur Adaption der Modellparameter und -zustandsgrößen wird zurückgeführt.

Gelöst wird diese Aufgabe gemäß der Erfindung durch die im Patentanspruch 1 sowie im Patentanspruch 5 angegebenen Merkmale. Weitere Ausgestaltungen der Erfindung sind Gegenstand von Unteransprüchen.

Ein wesentlicher Aspekt der Erfindung besteht darin, eine Batterie-Betriebsgröße (z.B. den Batteriestrom oder die Klemmenspannung) mit Hilfe eines mathematischen Batteriemodells zu berechnen, bei dem sowohl ein proportionaler, ein integraler als auch ein differentieller Anteil eines Fehlers zwischen einer gemessenen Batterie-Betriebsgröße (Batteriespannung, -strom oder -temperatur) und der vom mathematischen Energiespeichermodell berechneten Batterie-Betriebsgröße ermittelt wird, die einzelnen Fehleranteile jeweils mit einem individuellen Gewichtungsfaktor zu gewichten und die gewichteten Anteile zu Korrekturzwecken in das Energiespeichermodell zurückzukoppeln. Jeder Zustandgröße und jedem Parameter sind vorzugsweise eigene Gewichtungsfaktoren zugeordnet. Das Energiespeichermodell umfasst verschiedene Korrekturgleichungen, mittels der die Zustandsgrößen und/oder Parameter des Batteriemodells unter Berücksichtigung der gewichteten Fehleranteile dann korrigiert werden können, um sie auf das tatsächliche Verhalten des Energiespeichers abzugleichen. Auf der Grundlage der so ermittelten korrigierten Zustandsgrößen und Parameter können dann wiederum verschiedene Batteriegrößen, wie z.B. der Ladezustand oder die aus der Batterie entnehmbare Ladung berechnet oder durch Modell basierte Prädiktion verschiedene Batteriegrößen vorhergesagt werden.

Ein derartiger Zustandsgrößen- und Parameterschätzer mit Rückkoppelung eines proportionalen, integralen und differenzierten, und gewichteten Fehleranteils hat den wesentlichen Vorteil, dass dynamische Fehler insbesondere durch den differenzierten Anteil, sowie statische (Offset-) Fehler insbesondere durch den Integralanteil wesentlich besser kompensiert werden können. Die zusätzliche Rückkoppelung und Berücksichtigung des differenzierten als auch des integralen Fehleranteils hat eine wesentlich höhere Korrekturwirkung als z.B. eine alleinige Rückkoppelung des Proportionalanteils, d.h. des absoluten Fehlers. Dadurch können die Zustandsgrößen und Parameter des Batteriemodells exakter und eindeutiger bestimmt und der zukünftige Batteriezustand genauer vorhergesagt werden als mit einer rein proportionalen Fehlerrückkoppelung.

Bei schnellen Laständerungen kann beispielsweise der ohmsche Innenwiderstand durch die Rückkopplung des gewichteten Fehlerdifferentials genauer ermittelt werden, da dadurch dynamische Fehler verstärkt zur Korrektur des Innenwiderstands beitragen. In vergleichbarer Weise werden Fehler von Zustandsgrößen oder Parametern, die einen statischen Offsetfehler zwischen modellierten und gemessenen Betriebsgrößen verursachen (z.B. eine Abweichung des Anfangsladezustands vom realen Wert) insbesondere durch den integralen Fehleranteil besser kompensiert.

Die Gewichtung der einzelnen rückgekoppelten Fehleranteile erfolgt vorzugsweise Arbeitspunkt abhängig. Der Arbeitspunkt ist dabei allgemein durch die aktuellen Werte der Eingangsgrößen (Batteriespannung, -strom oder -temperatur) und der Zustandsgrößen des Batteriemodells definiert. Durch eine Arbeitspunkt abhängige Gewichtung der rückgekoppelten Fehleranteile ist es z.B. möglich, für die Korrektur der Zustandsgröße "Innenwiderstand" im Ladebetrieb der Batterie nur den differenzierten Fehleranteil und im Entladebetrieb alle drei Fehleranteile zu berücksichtigen. Dies ist bei der Korrektur des Innenwiderstands sinnvoll, da im Ladefall die üblichen Batteriemodelle den absoluten Verlauf der Batterie-Betriebsgrößen im Gegensatz zu ihren relativen Änderungen nur ungenau nachbilden.

Die Arbeitspunkt abhängige Gewichtung der rückgekoppelten Fehleranteile ist vorzugsweise derart realisiert, dass diejenige Zustandsgröße bzw. derjenige Parameter am stärksten korrigiert wird, die bzw. der sich im jeweiligen Arbeitspunkt am stärksten auf den zeitlichen Verlauf, den integrierten Verlauf oder den differenzierten Verlauf der abzugleichenden Batterie-Betriebsgröße auswirkt. Dadurch kann der Fehler zwischen gemessener Betriebsgröße und modellbasiert berechneter Betriebsgröße schnell kompensiert werden.

Darüber hinaus wird der integrierte Fehleranteil vorzugsweise dann nicht zur Korrektur einer Zustandsgröße oder eines Parameters berücksichtigt, wenn deren Korrekturgleichungen bereits ein Integralverhalten aufweisen. So wird z.B. bei der Korrektur der Ruhespannung oder des Innenwiderstands der integrierte Fehleranteil vorzugsweise nicht berücksichtigt.

Der erfindungsgemäße Zustandsgrößen- und Parameterschätzer umfasst vorzugsweise ein einziges Energiespeichermodell, das für den gesamten Arbeitsbereich des Energiespeichers Gültigkeit hat. Eine Verwendung unterschiedlicher Teilmodelle für verschiedene Arbeitsbereiche ist in diesem Fall nicht erforderlich, wodurch der Aufwand für die Erstellung des Energiespeichermodells wesentlich geringer wird.

Die Erfindung wird nachstehend anhand der beigefügten Zeichnungen beispielhaft näher erläutert. Es zeigen:

Fig. 1 die prinzipielle Struktur eines Zustandsgrößen- und Parameterschätzers gemäß einer Ausführungsform der Erfindung;

Fig. 2 ein Ersatzschaltbild eines Bleiakkumulators; und

Fig. 3 die prinzipielle Struktur eines Innenwiderstands-Schätzers.

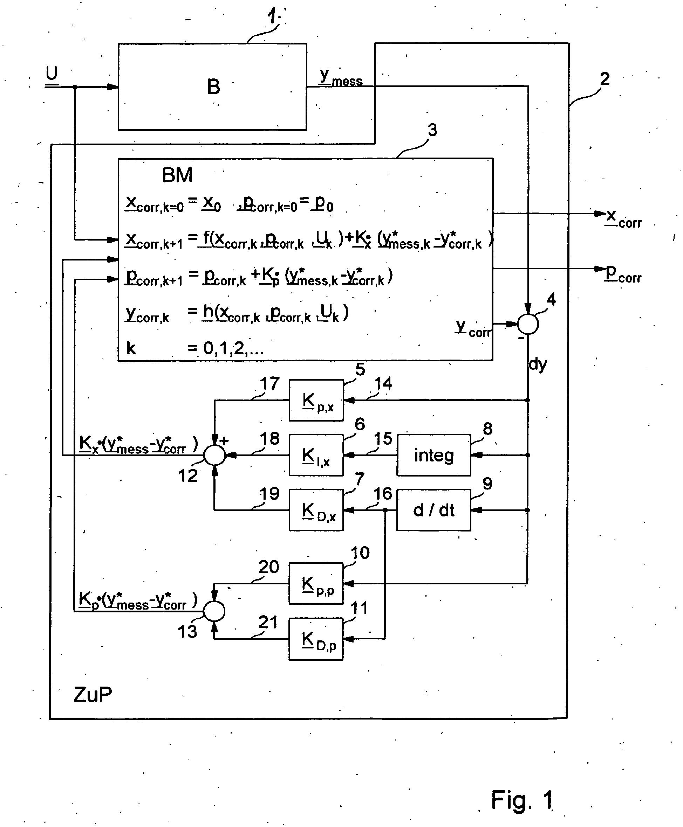

Fig. 1 zeigt eine Blockdarstellung der wesentlichen Funktionen eines Zustandsgrößen- und Parameterschätzers 2, der dazu dient, verschiedene Zustandsgrößen x, Parameter p und Betriebsgrößen y eines Batteriemodells 3 zu berechnen. Die ermittelten Zustandsgrößen x und Parameter p können dann zur Berechnung verschiedener Batteriegrößen, wie z.B. des Ladezustands, der Leistungsfähigkeit, der entnehmbaren Ladung, etc., sowie zur Prädiktion der Batteriegrößen genutzt werden.

Das Batteriemodell 3 ist ein mathematischen Modell, das die auf verschiedenen physikalischen Effekten beruhenden elektrischen oder thermischen Eigenschaften der Batterie anhand verschiedener mathematischer Modelle darstellt. Die mathematischen Modelle beschreiben funktionale Zusammenhänge zwischen den Zustandsgrößen, wie beispielsweise Spannungen, Strömen, Temperatur, etc. und umfassen verschiedene Parameter p.

Das Batteriemodell 3 ist im vorliegenden Beispiel als universelles Modell realisiert, das das Verhalten der Batterie 1 im gesamten Arbeitsbereich beschreibt.

Das Batteriemodell 3 verarbeitet eine oder mehrere Eingangsgrößen u und berechnet daraus die Zustandsgrößen x und Parameter p, die den aktuellen Zustand der Batterie 1 beschreiben. Unter der Bezeichnung Eingangsgröße' werden dabei eine, maximal zwei der externen Messgrößen "Batteriestrom" $I_{Bat,mess}$, "Batterietemperatur" $T_{Bat,mess}$ und "Batteriespannung" $U_{Bat,mess}$ verstanden.

Daneben erzeugt das Batteriemodell 3 eine Ausgangsgröße $y_{corr}$, die am Knoten 4 von einer gemessenen Betriebsgröße $y_{mess}$ der Batterie 1 subtrahiert wird. Die Ausgangsgröße $y_{corr}$ ist dabei eine geschätzte Batterie-Betriebsgröße (Strom $I_{Bat,mess}$, Temperatur $T_{Bat,mess}$, Spannung $U_{Bat,mess}$) die auch als Messgröße zur Verfügung steht, jedoch ohne die als Eingangsgröße u verwendete Betriebsgröße.

Der am Knoten 4 berechnete Fehler dy zwischen der Modell basiert berechneten Betriebsgröße $y_{corr}$ und der gemessenen Betriebsgröße $y_{mess}$ (z.B. Batteriestrom $I_{Bat,mess}$, Batteriespannung $U_{Bat,mess}$ oder Batterietemperatur $T_{Bat,mess}$) wird dann für jede Zustandsgröße x und jeden Parameter p individuell weiterverarbeitet und in das Batteriemodell 3 rückgekoppelt. Im Rückkoppelpfad des Batteriemodells ist ein Integrator 8 und ein Differenzierer 9 vorgesehen, die den absoluten Fehler dy integrieren bzw. differenzieren. Ferner sind Gewichtungseinheiten 5-7,10,11 vorgesehen, die die einzelnen Fehleranteile (den absoluten Fehler 14, den integrierten Fehler 15 und den differenzierten Fehler 16) für jede Zustandsgröße x und jeden Parameter p individuell gewichten. Die einzelnen Zustandsgrößen x und Parameter p werden im Batteriemodell 3 mittels Korrekturgleichungen ($x_{corr,k+1}=...$, $p_{corr,k+1}=...$) solange korrigiert, bis der Fehler dy kompensiert ist.

Das Verhalten der Batterie kann zur Implementierung in einem digitalen Rechner allgemein als nicht lineares zeitdiskretes Differenzengleichungssystem erster Ordnung dargestellt werden, wobei gilt:

$$\underline{X}_{k=0} = \underline{x}_0 \qquad (1)$$

$$\underline{X}_{k+1} = \underline{f}(\underline{x}_k, \underline{p}, \underline{u}_k) \qquad (2)$$

$$\underline{Y}_k = \underline{h}(\underline{x}_k, \underline{p}, \underline{u}_k) \qquad (3)$$

$k = 0, 1, ...$

wobei

$\underline{u}_k$ = Vektor der Eingangsgrößen des Energiespeichermodells 3 im Zeitschritt k (mindestens eine, maximal zwei der gemessenen Batterie-Betriebsgrößen $I_{Bat,mess}$, $U_{Bat,mess}$, $T_{Bat,mess}$).

$\underline{x}_k$ = Vektor der Zustandsgrößen des Energiespeichermodells 3 im Zeitschritt k, wie z.B. die Ruhespannung $U_{C0}$, die Durchtrittspolarisation $U_D$, Konzentrationspolarisation $\underline{U}_k$ mit dem Startwert $\underline{x}_0$.

$\underline{y}_k$ = Vektor der Ausgangsgrößen des Energiespeichermodells 3 im Zeitschritt k, und umfasst modellierte Betriebsgrößen y, die auch als Messgrößen $y_{mess}$ zur Verfügung stehen, jedoch ohne die als Eingangsgrößen $\underline{u}_k$ verwendeten Betriebsgrößen.

$\underline{p}$ = Vektor der zu schätzenden Parameter des Energiespeichermodells 3.

$\underline{f}(\underline{x}_k, \underline{p}, \underline{u}_k)$ = rechte Seite der Zustandsdifferenzengleichungen des Energiespeichermodells 3 und

$\underline{h}(\underline{x}_k, \underline{p}, \underline{u}_k)$ = Vektor der Ausgangsgleichungen des Energiespeichermodells 3.

Das Batteriemodell 3 arbeitet im wesentlich wie folgt:

Die Zustandsgrößen x und Parameter p werden zunächst auf einen Anfangszustand $x_0$ bzw. $p_0$ initialisiert und im Falle eines Fehlers dy zwischen der geschätzten und der gemessenen Ausgangsgröße y korrigiert. Das Batteriemodell umfasst hierzu Korrekturgleichungen ($x_{corr,k+1}=...$, $p_{corr,k+1}=...$), die unter Berücksichtung des proportionalen 14, integrierten 15 und differenzierten 16 Fehlers dy korrigierte Zustandsgrößen $\underline{x}_{corr}$, korrigierte Parameter $\underline{p}_{corr}$ und korrigierte. Ausgangsgrößen $\underline{y}_{corr}$ berechnen. Die einzelnen Fehleranteile 14-16 werden, wie erwähnt, mittels eines im Rückkoppelpfad angeordneten Integrators 8 und eines Differenzierers 9 erzeugt und anschließend individuell und Arbeitspunkt abhängig gewichtet. Die Gewichtungsfaktoren sind jeweils mit dem Buchstaben K bezeichnet, wobei der Index p den Gewichtungsfaktor $K_p$ für den proportionalen Fehleranteil 14, der Index I den Gewichtungsfaktor $K_I$ für den integrierten Anteil 15 und der Index D den Gewichtungsfaktor $K_D$ für den differenzierten Fehleranteil 16 bezeichnet. Die gewichteten Fehleranteile 17-19 werden schließlich am Knoten 12 addiert und zur Korrektur der Zustandsgrößen $\underline{x}$ in das Batteriemodell 3 rückgekoppelt.

Für die Korrektur der Parameter p sind ebenfalls Gewichtungseinheiten 10,11 vorgesehen, die den proportionalen Fehleranteil 14 und den differenzierten Fehleranteil 16 gewichten. Der integrierte Fehleranteil 15 wird bei der Korrektur der Parameter p nicht berücksichtigt, da die Korrekturgleichungen der Parameter, wie z.B. des Innenwiderstands $R_i$ oder der Ruhespannung $U_{C0}$ bereits ein Integralverhalten aufweisen.

Die gewichteten Fehleranteile 20,21 werden wiederum an einem Knoten 13 addiert und in das Batteriemodell 3 rückgekoppelt.

Für die Korrektur der Zustandsgrößen $x_{corr}$, Parameter $p_{corr}$ und Ausgangsgrößen $y_{corr}$ gelten folgende Beziehungen:

$$\text{Anfangswerte:} \quad \underline{x}_{corr,0} = \underline{x}_0 \ , \ \underline{p}_{corr,0} = \underline{p}_0 \qquad (4)$$

$$\underline{x}_{corr} = \underline{x} + \underline{K}_{p,x} * (\underline{y}_{mess} - \underline{y}_{corr}) + \underline{K}_{I,x} * integ (\underline{y}_{mess} - \underline{y}_{corr}) dt +$$

$$.... \underline{K}_{D,x} * d(\underline{y}_{mess} - \underline{y}_{corr}) /dt \qquad (5)$$

$$\underline{p}_{or} = \underline{p} + \underline{K}_{p,p} *(\underline{y}_{mess} - \underline{y}_{corr}) + \underline{K}_{I,p} * integ(\underline{y}_{mess} - \underline{y}_{corr}) dt +$$

$$.... \underline{K}_{D,p} * d(\underline{y}_{mess} - \underline{y}_{corr}) /dt \qquad (6)$$

$$\underline{y}_{corr} = \underline{h} (\underline{x}_{corr}, \underline{p}_{corr}, \underline{u}) \qquad . \qquad (7)$$

Ersetzt man in Gleichung (5) $\underline{x}$ durch $\underline{f} (\underline{x}_k, \underline{p}, \underline{u}_k)$ gemäß Gleichung (2) und die Zustandsgrößen $\underline{x}$ und Parameter $\underline{p}$ in den Gleichungen (5),(6) in jedem Zeitschritt k durch die korrigierten Größen $\underline{x}_{corr}$, $\underline{p}_{corr}$ erhält man die folgende rekursive Darstellung des Schätzalgorithmus:

$$\underline{x}_{corr,k=0} = \underline{x}_o , \quad \underline{p}_{corr,k=0} = \underline{p}_0, \qquad (8)$$

$$\underline{x}_{corr,k+1} = \underline{f}(\underline{x}_{corr,k}, \underline{p}_{corr,k}, \underline{u}_k) + \underline{K}_{p,x} * (\underline{y}_{mess,k} - \underline{y}_{corr,k}) + ....\underline{K}_{I,x}$$

$$* Summe (\underline{y}_{mess,I} - \underline{y}_{corr,i}) * t_{sample} + .... \underline{K}_{D,x} * [ (\underline{y}_{mess,k} - \underline{y}_{corr,k}) -$$

$$(\underline{y}_{mess,k-1} - \underline{y}_{corr,k-1}) ] /t_{sample} \qquad (9)$$

$$\underline{p}_{corr,k+1} = \underline{p}_{corr,k} + \underline{K}_{p,p} *(\underline{y}_{mess,k} - \underline{y}_{corr,k}) + ... \underline{K}_{D,p} * [ (\underline{y}_{mess,k} -$$

$$\underline{y}_{corr,k}) - (\underline{y}_{mess,k-1} - \underline{y}_{corr,k-1}) ] /t_{sample} \qquad (10)$$

$$\underline{y}_{corr,k} = \underline{h} (\underline{x}_{corr,k}, \underline{p}_{corr,k}, \underline{u}_k) \qquad (11)$$

k = 0,1,...

mit $t_{sample}$ = Abtastzeit

Bei der Parameterkorrektur in Gleichung (10) kann der Integralanteil entfallen, da sich durch den Ersatz der Modellparameter durch die korrigierten Größen eine rückgekoppelte Struktur mit Integralverhalten ergibt. Der Integralanteil kann auch für Zustandsgrößen entfallen, die bereits ein integrierendes Verhalten aufweisen, wie z.B. für die Ruhespannung $U_{C0}$.

Diese Struktur entspricht einem Zustandsbeobachter mit zusätzlicher Rückkoppelung des integrierten und differenzierten Ausgangsfehlers. Diese Gleichungen können in die Standardstruktur eines Zustandsbeobachters mit den Verstärkungsmatrizen $\underline{K}_x$ und $\underline{K}_p$ überführt werden:

$$Anfangswerte: \underline{x}_{corr,k=0} = \underline{x}_0, \quad \underline{p}_{corr,k=0} = \underline{p}_0 \qquad (12)$$

5

$$\underline{x}_{corr,k+1} = \underline{f}(\underline{x}_{corr,K}, \underline{p}_{corr,k}, \underline{u}_K) + \underline{K}_x * (\underline{y}^*_{mess,k} - \underline{y}^*_{corr,k}) \qquad (13)$$

$$\underline{p}_{corr,k+1} = \underline{p}_{corr,k} + \underline{K}_p * (\underline{y}^*_{mess,k} - \underline{y}^*_{corr,k}) \qquad (14)$$

$$\underline{K}_x = [\underline{K}_{p,x}\ \underline{K}_{I,x}\ \underline{K}_{D,x}], \quad \underline{K}_p = [\underline{K}_{p,p}\ \underline{0K}_{D,p}] \qquad (15)$$

$$\underline{y}^*_{corr,k} = [\underline{y}_{corr,k};\ \text{Summe}(\underline{y}_{corr,I}) * t_{sample};$$
$$(\underline{y}_{corr,k} - \underline{y}_{corr,k-1})/t_{sample}] \qquad (16)$$

$$\underline{y}^*_{mess,k} = [\underline{y}_{mess,k};\ \text{Summe}(\underline{y}_{mess,I}) * t_{sample};$$
$$(\underline{y}_{mess,k} - \underline{y}_{mess,k-1})/t_{sample}] \qquad (17)$$

k = 0,1 ....

mit $t_{sample}$ = Abtastzeit

Die Verstärkungsmatrizen $\underline{K}_x$ und $\underline{K}_p$ der Fehlerrückkopplungen können durch Polvorgabe entsprechend einem Luenberger-Beobachter oder durch Minimierung eines Gütekriteriums, wie z.B. der minimalen Schätzfehlervarianz (Kalman-Filter) bestimmt werden. Bei nicht linearen Modellen müssen die Modellgleichungen dazu zuvor um den aktuellen Arbeitspunkt linearisiert werden.

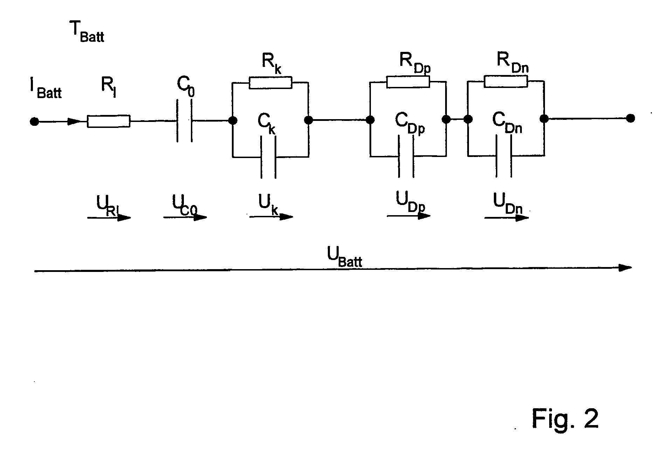

Fig. 2 zeigt das Ersatzschaltbild eines Bleiakkumulators. Die Zählrichtung des Batteriestroms $I_{Batt}$ ist wie üblich positiv für Laden und negativ für Entladen gewählt. Dabei wird zwischen Betriebsgrößen, Zustandsgrößen und Parametern unterschieden:

Betriebsgrößen:

$I_{Batt}$ = Batteriestrom
$U_{Batt}$ = Batteriespannung
$T_{Batt}$ = Batterietemperatur

Zustandsgrößen:

$U_{C0}$ = Ruhespannung
$U_K$ = Konzentrationspolarisation
$U_{Dp}$ = Durchtrittspolarisation der positiven Elektrode
$U_{Dn}$ = Durchtrittspolarisation der negativen Elektrode

Parameter:

$R_I$ = ohmscher Innenwiderstand, abhängig von der Ruhespannung $U_{C0}$, der Konzentrationspolarisation $U_k$ und der Säuretemperatur $T_{Batt}$
$C_0$ = Ersatzkapazität der Batterie
$R_k$, $C_k$ = Säurediffusionswiderstand bzw. -kapazität

$R_{Dp}$, $C_{Dp}$ = Widerstand und Kapazität der Doppelschicht der positiven Elektrode
$R_{Dn}$, $C_{Dn}$ = Widerstand und Kapazität der Doppelschicht der negativen Elektrode

Die einzelnen Größen sind zurückzuführen auf verschiedene physikalische Effekte der Batterie, die aus der Literatur hinreichend bekannt sind und daher nicht weiter erläutert werden.

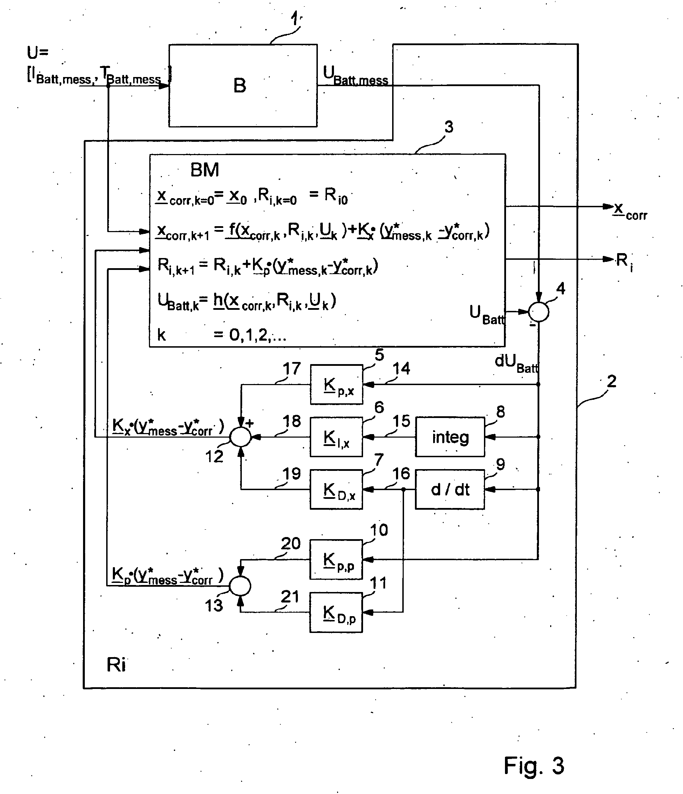

Fig. 3 zeigt die Struktur eines Zustandsgrößen- und Parameterschätzers 2, der zur Berechnung des Innenwiderstands $R_i$ eingerichtet ist. Der ohmsche Innenwiderstand $R_i$ des Energiespeichers 1 ist eine entscheidende Größe bei der Bestimmung der Leistungsfähigkeit der Batterie 1 und wird daher ständig überwacht.

Eingangsgrößen des Batteriemodells 3 sind in diesem Fall der gemessene Batteriestrom $I_{Batt,mess}$ und die Batterietemperatur $T_{Batt,mess}$. Ausgangsgröße des Batteriemodells 3 ist dabei die Batteriespannung $U_{Batt}$. Der Messfehler $dU_{Batt}$ berechnet sich aus der geschätzten Batteriespannung $U_{Batt}$ und der gemessenen Batteriespannung $U_{Batt,mess}$.

Zur Korrektur der Zustandsgrößen $\underline{x}$ wird der Messfehler $dU_{Batt}$ wiederum integriert (Einheit 8) und differenziert (Einheit 9) und die einzelnen Anteile 14,15,16 individuell gewichtet. Der gewichtete Messfehler $\underline{K}_x * (\underline{y}^*_{mess} - \underline{y}^*_{corr})$ wird dann zur Korrektur der Zustandsgrößen $\underline{x}$ in das Batteriemodell 3 rückgekoppelt. Die Zustandsgrößen $\underline{x}$ und der ohmsche Innenwiderstand $R_i$ werden so abgeglichen, dass die einzelnen Fehleranteile 14-16 minimiert werden.

Bei der Korrektur des Innenwiderstands $R_i$ und der Ruhespannung $U_{C0}$ wird der integrierte Messfehler $dU_{Batt}$ nicht berücksichtigt, da deren Korrekturgleichungen bereits Integralverhalten aufweisen. Darüber hinaus wird der proportionale und integrierte Messfehler 14,15 vorzugsweise nur für den Entladefall rückgekoppelt und im Ladefall nicht berücksichtigt, um eine Fehladaption im Ladebetrieb aufgrund der größeren Modellungenauigkeit zu vermeiden. Der ohmsche Innenwiderstand $R_i$ wird also beim Entladen sowohl durch den proportionalen als auch den differenzierten Fehler, beim Laden nur durch den differenzierten Fehler 16 korrigiert.

Bezugszeichenliste

| | |
|---|---|
| 1 | Batterie |
| 2 | Zustandsgrößen- und Parameterschätzer |
| 3 | Batteriemodell |
| 4 | Subtrahierknoten |
| 5-7 | Verstärkungsfaktoren für die Zustandsgrößen |
| 8 | Integrator |
| 9 | Differenzierer |
| 10,11 | Verstärkungsfaktoren für die Parameter |
| 12,13 | Addierknoten |
| 14 | proportionaler Fehleranteil |
| 15 | integrierter Fehleranteil |
| 16 | differenzierter Fehleranteil |
| 17-19 | verstärkte Fehleranteile der Zustandsgrößen |
| 20,21 | gewichteter Fehler für die Parameterkorrektur |
| u | Eingangsgrößen |
| $Y_{mess}$ | gemessene Betriebsgrößen |
| $Y_{corr}$ | berechnete Betriebsgrößen |
| $X_{corr}$ | berechnete Zustandsgrößen |
| $p_{corr}$ | berechnete Parameter |
| dy | Fehler zwischen gemessener und geschätzter Betriebsgröße |
| $K_p$ | Gewichtungsfaktor für den proportionalen Fehleranteil |
| $K_I$ | Gewichtungsfaktor für den integrierten Fehleranteil |
| $K_D$ | Gewichtungsfaktor für den differenzierten Fehleranteil |
| $R_i$ | Innenwiderstand der Batterie |
| $C_0$ | Ersatzkapazität der Batterie |
| $R_k$ | Säurediffusionswiderstand |
| $C_k$ | Säurediffusionskapazität |
| $R_{Dp}$ | Widerstand der Doppelschicht der positiven Elektrode |
| $R_{Dn}$ | Widerstand der Kapazität der Doppelschicht der negativen Elektrode |
| $C_{Dp}$ | Kapazität der Doppelschicht der positiven Elektrode |
| $C_{Dn}$ | Kapazität der Doppelschicht der negativen Elektrode |
| $I_{Batt}$ | Batteriestrom |

$U_{Batt}$     Batteriespannung
$T_{Batt}$     Batterietemperatur

**Patentansprüche**

1.  Vorrichtung zum Ermitteln von Zustandsgrößen (x) und/oder Parametern (p) eines mathematischen Batteriemodells (3), das die elektrischen Eigenschaften einer Batterie (1) beschreibt, **gekennzeichnet, dass**

    - der Fehler (dy,14) zwischen einer gemessenen Batterie-Betriebsgröße ($y_{mess}$) und einer vom Batteriemodell (3) berechneten Batterie-Betriebsgröße ($y_{cor}$), ein differenzierter Anteil (15) des Fehlers (dy), sowie ein integrierter Anteil (16) des Fehlers (dy) berechnet,
    - der proportionale Anteil (dy,14), der differenzierte Anteil (15) und der integrierte Anteil (16) jeweils mit einem Gewichtungsfaktor (K) gewichtet und
    - die gewichteten Anteile (17-21) zur Korrektur der Zustandsgrößen (x) und/oder der Parameter (p) in das Batteriemodell (3) rückgekoppelt werden.

2.  Vorrichtung nach Anspruch 1, **dadurch gekennzeichnet, dass** die Gewichtung des proportionalen (14), den integrierten (15) und/oder des differenzierten Anteils (16) arbeitspunktabhängig durchgeführt wird.

3.  Vorrichtung nach Anspruch 1 oder 2, **dadurch gekennzeichnet, dass** das Batteriemodell (3) als ein universelles Modell realisiert ist, das für den gesamten Arbeitsbereich der Batterie (1) Gültigkeit hat.

4.  Vorrichtung nach Anspruch 2, **dadurch gekennzeichnet, dass** die arbeitspunktabhängige Gewichtung der einzelnen Fehleranteile derart realisiert ist, dass diejenige Zustandsgröße (x) bzw. derjenige Parameter (p) am stärksten korrigiert wird, die bzw. der sich im jeweiligen Arbeitspunkt am stärksten auf den zeitlichen Verlauf, den integralen Verlauf oder den differentiellen Verlauf der abzugleichenden Betriebsgröße ($y_{mess}$) auswirkt.

5.  Vorrichtung nach Anspruch 2, **dadurch gekennzeichnet, dass** der proportionale (14), der integrale (15) und/oder der differentielle (16) Anteil des Fehlers (dy) beim Laden der Batterie (1) anders gewichtet werden als beim Entladen der Batterie (1).

6.  Verfahren zum Ermitteln von Zustandsgrößen (x) und/oder Parametern (p) eines mathematischen Batteriemodells (3), das die elektrischen Eigenschaften einer Batterie (1) anhand verschiedener Zustandsgrößen (x) und Parameter (p) beschreibt, wobei das mathematische Batteriemodell (3) Korrekturgleichungen aufweist, mittels der die Zustandsgrößen (x) und/oder die Parameter (p) korrigiert und auf das tatsächliche Betriebsverhalten der Batterie abgeglichen werden, **dadurch gekennzeichnet, dass**

    - der Fehler zwischen einer gemessenen Batterie-Betriebsgröße ($y_{mess}$) und einer vom Batteriemodell (3) berechneten Batterie-Betriebsgröße ($y_{corr}$) berechnet,
    - ein differenzierter Anteil (15) des Fehlers sowie ein integrierter Anteil (16) des Fehlers berechnet
    - der proportionale Anteil (14), der differenzierte Anteil (15) und der integrierte Anteil (16) jeweils mit einem Gewichtungsfaktor (K) gewichtet, und
    - die gewichteten Fehleranteile (17-21) zur Korrektur der Zustandsgrößen (x) und/oder der Parameter (p) in das Batteriemodell (3) rückgekoppelt werden.

7.  Verfahren nach Anspruch 5, **dadurch gekennzeichnet, dass** die Gewichtung des proportionalen (dy), den integrierten (15) und/oder des differenzierten Anteils (16) arbeitspunktabhängig durchgeführt wird.

8.  Verfahren nach Anspruch 5 oder 6, **dadurch gekennzeichnet, dass** das Batteriemodell (3) als ein einziges Modell für den gesamten Arbeitsbereich der Batterie (1) realisiert ist.

9.  Verfahren nach einem der Ansprüche 5 bis 7, **dadurch gekennzeichnet, dass** die arbeitspunktabhängige Gewichtung der einzelnen Fehleranteile derart realisiert ist, dass diejenige Zustandsgröße (x) bzw. derjenige Parameter (p) am stärksten korrigiert wird, die bzw. der sich im jeweiligen Arbeitspunkt am stärksten auf den zeitlichen Verlauf, den integralen Verlauf oder den differentiellen Verlauf der abzugleichenden Betriebsgröße ($y_{mess}$) auswirkt.

**Claims**

1. Apparatus for determining state variables (x) and/or parameters (p) of a mathematical battery model (3) which describes the electrical properties of a battery (1), **characterized in that**

   - the error (dy, 14) between a measured battery operating variable ($y_{meas}$) and a battery operating variable ($y_{corr}$) calculated by the battery model (3), a differentiated component (15) of the error (dy) and an integrated component (16) of the error (dy) are calculated,
   - the proportional component (dy, 14), the differentiated component (15) and the integrated component (16) are in each case weighted with a weighting factor (K), and
   - the weighted components (17-21) are fed back to the battery model (3) in order to correct the state variables (x) and/or the parameters (p).

2. Apparatus according to Claim 1, **characterized in that** the proportional component (14), the integrated component (15) and/or the differentiated component (16) are weighted as a function of the operating point.

3. Apparatus according to Claim 1 or 2, **characterized in that** the battery model (3) is implemented as a universal model which is applicable to the entire operating range of the battery (1).

4. Apparatus according to Claim 2, **characterized in that** the operating-point-dependent weighting of the individual error components is implemented in such a way that that state variable (x) or that parameter (p) which, at the respective operating point, has the greatest effect on the time profile, the integral profile or the differential profile of the operating variable ($y_{meas}$) to be adjusted is corrected to the greatest extent.

5. Apparatus according to Claim 2, **characterized in that** the proportional component (14), the integral component (15) and/or the differential component (16) of the error (dy) are weighted differently during charging of the battery (1) than during discharging of the battery (1).

6. Method for determining state variables (x) and/or parameters (p) of a mathematical battery model (3) which describes the electrical properties of a battery (1) on the basis of various state variables (x) and parameters (p), with the mathematical battery model (3) having correction equations by means of which the state variables (x) and/or the parameters (p) are corrected and adjusted to the actual operating behaviour of the battery, **characterized in that**

   - the error between a measured battery operating variable ($y_{meas}$) and a battery operating variable ($y_{corr}$) calculated by the battery model (3) is calculated,
   - a differentiated component (15) of the error and an integrated component (16) of the error are calculated,
   - the proportional component (14), the differentiated component (15) and the integrated component (16) are in each case weighted with a weighting factor (K), and
   - the weighted error components (17-21) are fed back to the battery model (3) in order to correct the state variables (x) and/or the parameters (p).

7. Method according to Claim 5, **characterized in that** the proportional component (dy), the integrated component (15) and/or the differentiated component (16) are weighted as a function of the operating point.

8. Method according to Claim 5 or 6, **characterized in that** the battery model (3) is implemented as a single model for the entire operating range of the battery (1).

9. Method according to one of Claims 5 to 7, **characterized in that** the operating-point-dependent weighting of the individual error components is implemented in such a way that that state variable (x) or that parameter (p) which, at the respective operating point, has the greatest effect on the time profile, the integral profile or the differential profile of the operating variable ($y_{meas}$) to be adjusted is corrected to the greatest extent.

**Revendications**

1. Dispositif pour déterminer les grandeurs d'état (x) et/ ou les paramètres (p) d'un modèle mathématique de batterie (3) ayant des caractéristiques électriques d'une batterie,
   **caractérisé en ce que**

- on calcule l'erreur (dy, 14) entre le paramètre de fonctionnement mesuré de la batterie ($y_{mess}$) et une grandeur de fonctionnement de batterie ($y_{cor}$) calculée sur la batterie, une composante différentiée (15) de l'erreur (dy) et une composante intégrée (16) de l'erreur (dy),
- on pondère la composante proportionnelle (dy), (14) de la composante différentiée (15) et de la composante intégrée (16) chaque fois avec un coefficient de pondération (K) et
- on effectue un couplage en réaction des composantes pondérées (17-21) pour corriger les grandeurs d'état (x) et/ou les paramètres (p) dans le modèle de batterie (3).

**2.** Dispositif selon la revendication 1,
**caractérisé en ce qu'**
on effectue la pondération de la composante proportionnelle (14), de la composante intégrée (15) et/ou de la composante différentiée (16) selon le point de fonctionnement.

**3.** Dispositif selon la revendication 1 ou 2,
**caractérisé en ce qu'**
on réalise le modèle de batterie (3) comme un modèle universel valable pour toute la plage de travail de la batterie (1).

**4.** Dispositif selon la revendication 2,
**caractérisé en ce qu'**
on réalise la pondération selon le point de fonctionnement des différentes composantes d'erreur de façon que la grandeur d'état (x) respective ou le paramètre (p) respectif le plus fortement corrigés sont la grandeur d'état (x) ou le paramètre (p) qui se répercute le plus fortement en chaque point de fonctionnement sur le déroulement dans le temps, sur le déroulement intégral ou sur le déroulement différentiel du paramètre de fonctionnement ($y_{mess}$) à compenser.

**5.** Dispositif selon la revendication 2,
**caractérisé en ce que**
la composante proportionnelle (14), la composante intégrale (15) et/ ou la composante différentielle (16) de l'erreur (dy) est pondérée différemment pendant la charge de la batterie (1) et pendant la décharge de la batterie (1).

**6.** Procédé pour déterminer les grandeurs d'état (x) et/ou les paramètres (p) d'un modèle mathématique de batterie (3) décrivant les propriétés électriques d'une batterie (1) à l'aide de différentes grandeurs d'état (x) et paramètres (p), le modèle mathématique de batterie (3) ayant des équations de correction à l'aide desquelles on corrige les grandeurs d'état (x) et/ou les paramètres (p) et par rapport auxquelles on compense le comportement effectif du fonctionnement de la batterie,
**caractérisé en ce qu'**

- on calcule l'erreur entre la grandeur de fonctionnement mesurée de la batterie ($y_{mess}$) et une grandeur de fonctionnement calculée ($y_{cor}$) d'une batterie (3),
- on calcule la composante différentiée (15) de l'erreur ainsi que la composante intégrale (16) de l'erreur,
- on pondère la composante proportionnelle (14), la composante différentiée (15) et la composante intégrée (16) chacune avec un coefficient de pondération (K) et
- on couple en réaction les composantes d'erreur pondérées (17-21) pour corriger les grandeurs d'état (x) et/ou les paramètres (p) dans le modèle de batterie (3).

**7.** Procédé selon la revendication 5,
**caractérisé en ce qu'**
on effectue la pondération de la composante proportionnelle (dy), de la composante intégrée (15) et/ou de la composante différentiée (16) selon le point de fonctionnement.

**8.** Procédé selon la revendication 5 ou 6,
**caractérisé en ce qu'**
on réalise le modèle de batterie (3) comme modèle unique pour toute la plage de travail de la batterie (1).

**9.** Procédé selon l'une des revendications 5 à 7,
**caractérisé en ce qu'**
on réalise la pondération des différentes composantes d'erreur selon le point de fonctionnement de façon à corriger le plus fortement la grandeur d'état (x) ou le paramètre (p) respectif qui interviennent en chaque point de fonctionnement le plus fortement sur l'évolution chronologique, l'évolution intégrale et l'évolution différentielle de la grandeur de fonctionnement ($y_{mess}$) à compenser.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5349540 A